Europäisches Patentamt

European Patent Office

Office européen des brevets

(11) Publication number: **0 309 982**
**A2**

# (12) EUROPEAN PATENT APPLICATION

(21) Application number: 88115864.6

(22) Date of filing: 27.09.88

(51) Int. Cl.⁴: **C08J 5/24 , H05K 1/03 , H01L 23/14**

(30) Priority: 30.09.87 US 103246

(43) Date of publication of application:
**05.04.89 Bulletin 89/14**

(84) Designated Contracting States:
**DE FR GB IT NL SE**

(71) Applicant: **E.I. DU PONT DE NEMOURS AND COMPANY**
**Legal Department 1007 Market Street**
**Wilmington Delaware 19898(US)**

(72) Inventor: **Bolt, John Davis**
**3309 Appleton-Kemblesville Road**
**Landenberg Pennsylvania 19350(US)**
Inventor: **Button, Daniel Paul**
**2401 Westfield Court**
**Newtown Square Pennsylvania 19073(US)**
Inventor: **Yost, Bruce Allen**
**14 Faith Circle**
**Newark Delaware 19711(US)**

(74) Representative: **von Kreisler, Alek,**
**Dipl.-Chem. et al**
**Patentanwälte Von Kreisler-Selting-Werner**
**Deichmannhaus am Hauptbahnhof**
**D-5000 Köln 1(DE)**

(54) **Polymer-ceramic composite plies.**

(57) A composite containing high purity crystalline ceramic fibers in a polymeric matrix, suitable for use as a microelectronic device package or circuit board. The composite exhibits high thermal conductivity, and low coefficients of thermal expansion in-plane, and moderate thermal conductivities and low dielectric constants out-of-plane.

Fiber

Matrix

Fig. 1

EP 0 309 982 A2

## POLYMER-CERAMIC COMPOSITE PLIES

### Field of the Invention

This invention relates to ceramic fiber-resin composite plies and laminates suitable for use as electronic substrates. More specifically, the invention relates to an improved composite containing a planar array of high purity ceramic fibers in a thermally stable polymer matrix and laminates thereof.

### Background of the Invention

Composites made from reinforcing fiber in a polymeric matrix are known and are used in applications ranging from high strength aerospace materials to sports equipment. Selection of both the polymeric matrix and fiber used in such composites is critical to the success of the entire composite in an intended application.

In the electronics area, composite materials such as common fiberglass (glass fiber in a polyester or epoxy resin matrix) have found widespread acceptance as a replacement for phenolic resins for the manufacture of circuit boards. More recently, glass/epoxy composites have found widespread use for circuit boards and for more specialized electronic applications such as chip packaging.

As microelectronic circuits become more dense and as their speeds increase, the properties of packaging materials which surround semiconductor devices become more critical. Moves toward increasing density through the use of chip-on-board and surface mount device techniques, in order to conserve board space and reduce interconnect distances, have necessitated the development of new methods for providing heat removal, reducing crosstalk, improving reliability, and providing operability at increased temperatures.

It is therefore of interest that a composite material which will be used as a microelectronic circuit package or substrate have high thermal conductivity, low dielectric constant, thermal stability at elevated temperatures and have a thermal expansion coefficient as close as possible to that of the mounted semiconductor device (e.g. the die or level one package).

### Information Disclosure Statement

. The prior art contains many references illustrating attempts to provide the desirable properties referred to above. U. S. Patent 4,563,488 to Minami et al. discloses the inclusion of 50-95 vol.% of a heat conductive inorganic powder in a resin matrix in order to increase thermal conductivity of the resulting insulator material. Similarly, U. S. Patent 4,574,897 to DeGree et al. discloses a thermally conductive, electrically insulative laminate comprising a center layer of polyimide filled with aluminum oxide or boron nitride particulate solids.

Suggestions for the use of alumina fibers including high purity alpha alumina fibers (sometimes combined with polyaramid fibers) as reinforcement for radar transparent structures, sporting goods, ballistic armor, and circuit boards appear in the literature of E. I. DuPont de Nemours & Co. Such reinforced structures are reported to have dielectric constants of 4.5-6.0 (at room temperature and 9.2 GHz), and ambient thermal conductivities of 0.46-1.67 W/m$\cdot$K (unknown direction of measurement).

No data, however, are currently known relative to the fiber orientations and lengths used in preparing the samples tested. The measurement techniques and conditions were also not reported and are not currently known. Furthermore, no data regarding any coefficients of thermal expansion of the composites are reported. It may be inferred from the flex strength and moduli data reported, however, that only unidirectional plies and composites were made and tested, and that the primary area of interest was in their use as radar-transparent structures.

U. S. Patent 4,609,586 to Jensen et al. discloses a printed wiring board laminate having a low coefficient of thermal expansion in the X-Y direction and having relatively high thermal conductivity. Jensen et al. disclose the coefficient of thermal expansion of a conventional glass fiber reinforced epoxy composite board as being approximately 14-17 ppm/$^\circ$C. Jensen's wiring board laminate comprises a graphite fiber-

2

containing metal matrix support in combination with a glass fiber reinforced resin board. When the combination is adhesively bound, the laminate has a coefficient of thermal expansion in the X-Y direction greater than that of the support (4 ppm/°C) and less than that of the wiring board (14-17 ppm/°C). Because the graphite reinforced metal support member is electrically conductive, extensive steps must be taken to insulate the laminated wiring boards and additional processing and insulation are necessary in order to provide for transverse structures (vias).

U. S. Patent 4,578,308 to Hani et al. discloses a laminated board made from a prepreg sheet of alumina paper impregnated with a thermosetting resin. The alumina paper is described by Hani as comprising alumina filaments having a fiber diameter of 100 microns or smaller and a filament length at least ten times the diameter. All of the examples presented by Hani employ Saffil® (a trademark of ICI Americas, Inc. of Wilmington, DE for alumina fiber) combined with cellulose fiber to form a paper.

Saffil is a short-fiber form of polycrystalline alumina. Although its manufacturer claims it to be of high purity, it is reported in the literature to be 95 wt.% alumina, and is a mixture of alpha and other forms of alumina, together with 5 wt.% silica. According to the advertising literature of the manufacturer, Saffil has low thermal conductivity. The silicate phase of Saffil is known to form glasses which degrade thermal conductivity. Moreover, cellulose binder phases and other paper process requirements serve to limit the loadings of inorganic fibers, and thus the levels of thermal conductivity obtainable. Hani et al. achieve thermal conductivities as high as 3.3 W/m°K (specimen 9) using an epoxy resin and alumina fill particles within the resin matrix. It must be noted, however, that Hani et al. do not report the technique, orientation, or conditions for their thermal conductivity data. Although a ratio of dimensional change relating dimensional stability in the in-plane and transverse dimensions is reported, no thermal expansion coefficients are reported for the material. Similarly, no dielectric constants were reported by Hani. It is expected that the dielectric constants of the materials made according to the teachings of Hani et al. would be moderately low because of the $SiO_2$ content of the Saffil material. It is also expected that the coefficient of thermal expansion should be relatively high because of the short fibers employed.


Brief Description of the Invention


The present invention is directed to polymer-ceramic dielectric plies having high in-plane thermal conductivity, moderately high out-of-plane thermal conductivity, and low thermal expansion coefficient in-plane, laminates including such plies, circuit boards and electronic substrates including such plies, and a method of making such plies, laminates, substrates and circuit boards. The substrate of the present invention is a single or multiple ply (also referred to as a composite laminate) sheet material, comprising a plurality of high thermal conductivity (>8W/m°K and preferably >30 W/m°K), low thermal expansion coefficient (<14ppm/°C from RT to 200°C), low dielectric constant (<12 at 1 KHz and above) pure, dense crystalline ceramic (inorganic, non-metallic solid) fibers embedded in a thermally stable, insulating resin matrix, and oriented in the plane of the ply (or plies). The fibers comprise 5-70 vol.%, and preferably at least 30 vol.% of the composite. In some embodiments, the fibers are also linearly aligned within the ply, and multiple plies are laid up with their respective linearly aligned fibers at predetermined angles to one another to provide quasi-isotropic in-plane properties in the laminate as a whole.

Resins useful in this invention must have a dielectric constant of at most 5 (at 1 KHz or higher). Resins having the requisite dielectric constant, and other desirable physical and processing properties, described in geater detail below, include polyimides, polyamides, epoxies, fluoropolymers, and other homo and co-polymers.

Crystalline ceramic fibers useful in this invention include pure, dense, alumina, aluminum nitride, silicon carbide, alpha quartz, beryllium oxide, boron nitride, silicon nitride, magnesium oxide, and diamond, of which alpha alumina and aluminum nitride are currently preferred. For maximum in-plane thermal conductivity, and minimum dielectric constant, the fibers should be as pure as possible, excluding, for example, glassy inclusions, or electrically conductive secondary phases. Thus, the most preferred fiber is alpha alumina of greater than 97 wt.% purity, and less than 10 vol.% porosity. While the fibers may be either continuous or discontinuous, and either single or multifilament, continuous multifilament fibers (sometimes referred to as yarns) are presently preferred in order to facilitate manufacture.

Each ply is made by assembling a planarly oriented plurality of ceramic fibers, surrounding the fibers (such as by impregnating or immersing them) in a hardenable liquid resin (which may be, for example, a resin precursor or an uncured resin) and then hardening the resin while trying to minimize void formation. In some cases, multiple plies (as well as optional metallic cladding sheets) may be laid up into a laminate before the resin is hardened. Insulating materials, metallic contacts, lead lines, or vias may then be bonded, etched or deposited on this substrate in predetermined patterns to make a circuit board, chip carrier, or other electronic device package which has, among other useful properties, high in-plane thermal conductivity, typically above 5 W/m$^\bullet$K. In the most preferred embodiment, isotropic in-plane thermal conductivities above 9 W/m$^\bullet$K have been achieved in a laminate approximately 0.036" (0.9mm) thick. Also typically achieved are in-plane coefficients of thermal expansion of less than 12 ppm/$^\bullet$C (RT-200$^\bullet$C), ambient out-of-plane thermal conductivities of greater than 0.3 W/m$^\bullet$K (and often >.5 W/m$^\bullet$K), and ambient out-of-plane dielectric constants of less than 12 at or above 1 KHz.

These properties are important because they permit substrates and microelectronics with denser chip packaging, faster operation, and higher reliability by providing short propagation delays, good heat conduction through the substrate away from heat sources in electronic chips to various cooling reservoirs. This, in turn, provides good heat dissipation for the packages generally, and reduction of in-plane thermal gradients and stresses. The plies of the present invention are also of much lower density than the metal layers commonly used to enhance heat conduction in the prior art.

## Brief Description of the Figures

Fig. 1 is a simplified cross section diagram of two ply unidirectional composite according to the present invention.

Fig. 2 is a simplified cross section diagram of a $[0/\pm60^\bullet]_s$ quasi-isotropic composite produced according to the present invention.

Fig. 3 is a simplified cross section diagram of a $[0/\pm45/90^\bullet]_s$ quasi-isotropic composite produced according to the present invention.

## Detailed Description of the Invention

The electronic substrate of the present invention is characterized by high in-plane thermal conductivity and moderate to high out-of-plane thermal conductivity, which functions to conduct heat away from electric component heat sources attached to the electronic substrate (circuit board), and thus to prevent damaging heat build-up. Enhanced thermal conductivity in-plane serves to spread heat from a mounted heat source such as a chip over a larger area which enhances convection cooling. Enhanced out-of-plan thermal conductivity improves heat transport through the substrate to various heat sinks which are often attached to the back side of the substrate. Furthermore, the substrates are characterized by relatively low thermal expansivities which are well matched to the thermal expansivity of the electronic devices and packages which are mounted on the substrates (3.5-8 ppm/$^\bullet$C). This match of expansivity reduces the mechanical stress which results when an electronic device and package temperature cycles during normal periods of operation. Isotropic or quasi-isotropic in-plane thermal expansivities improve the thermal-mechanical reliability of the microelectronic devices and packages using the substrates of the present invention. These properties are achieved through the use of a composite ply material, of which both the filler material and the resin matrix material are selected for the generally well-known properties necessary for high-performance microelectronic packaging. More importantly, surprisingly better performance is achieved, however, by the combination of high performance, thermally stable resins and high purity crystalline ceramic fibers disposed in the ply in a planarly oriented array. Many key properties are achieved by specially orienting continuous fibers within the substrates. Specifically, extremely high ceramic loadings (up to approximately 70 vol.%) may be achieved in substantially void-free, free standing laminates having improved thermal and mechanical properties. At high ceramic loadings, out-of-plane as well as in-plane thermal conductivities are enhanced while maintaining out-of-plane dielectric constant at low levels comparable to the polymer itself.

It has been confirmed that up to at least 40 vol.% the thermal conductivity of the unidirectional plies of the present invention is linearly related to the cross-sectional area of ceramic fibers in the direction of measurement. Thus, for different loadings of ceramic fiber in the unidirectional ply, thermal conductivity varies with the volume percent of ceramic in the ply. Using this relationship, a thermal conductivity for the fibers alone has been extrapolated (corresponding to a composite with 100% fiber loading).

Because of the requirements of high temperature processability and cladding with conductive materials such as copper foil, the polymer matrix from which the composite of the present invention are formed must be able to withstand high temperature operations, (such as soldering, which commonly employs temperatures on the order of 250-500° C.) The resin must not deform or melt in such processing steps, and must exhibit sufficient thermal, structural (resistance to delamination or excessive shrinkage or expansion), and chemical stability (the material must not decompose or volatilize) to survive soldering and electronic equipment operating temperatures. The polymeric material must also be wettable in order to provide good adhesion to high surface energy materials including metal foils and the ceramic fiber itself.

Polymers having these characteristics include (among others): polyimides, polyamides, epoxies, polyetherimides, polyamide-imides, fluoropolymers, polyarylates, polyetherketones, polyetherketoneketones, polysulfones, polyphenylene sulfides, bismaleimide resins, phenolic resins, polyesters, polybutadiene, polyetheretherketones, cyanate esters, and modified resins and copolymers of these. Polyimides such as K-Polymers (e.g. K-II or K-III from E.I. DuPont de Nemours & Co., Inc. of Wilmington, DE), are preferred because of their high temperature performance, low dielectric constants, and overall processability.

Ceramics which may be employed in the invention include crystalline ceramics which are pure, dense, electrically insulative, have relatively low coefficients of thermal expansion, and relatively high thermal conductivities. (Saffil, for example, which is characterized by its manufacturer as a thermal insulator, and which is 5 wt.% silica, is not an appropriate ceramic material because of its low thermal conductivity.) Ceramic fibers useful in this invention include pure, dense alumina, aluminum nitride, silicon carbide, alpha quartz, beryllium oxide, boron nitride, silicon nitride, magnesium oxide, and diamond, of which alpha alumina and aluminum nitride are presently preferred. For maximum in-plane thermal conductivity, and minimum dielectric constant, the fibers should be as pure as possible, excluding, for example, glassy inclusions and lossy or electrically conductive second phases. Thus, the most preferred fiber is alpha alumina of greater than 97 wt.% purity (i.e. free of alkali or silica compounds), and less than 10 vol.% (and preferably less than 3 vol.%) porosity. While the fibers may be either continuous or discontinuous, and either single or multifilament, continuous multifilament fibers (sometimes referred to as yarns) are presently preferred in order to facilitate manufacture. The use of continuous fibers allows the production of plies and composites hav ing extraordinarily high filler loadings and superior thermal and mechanical properties.

Alumina which is greater than 97 wt.% alpha phase and preferably greater than 99 wt.% alpha phase has been found to be preferable. Where alpha alumina is the ceramic of choice, high purity alumina such as Fiber FP® (a trademark of E.I. DuPont de Nemours & Co., Inc. of Wilmington, DE for continuous high purity alpha alumina fibers) is preferred. Alternatively, aluminum nitride fibers, such as those disclosed in U.S. Patent Application Serial No. 503,448, filed September 4, 1986 (now allowed) and U.S. Patent Application Serial No. 903,486, filed September 4, 1986 (both of common assignment herewith), are also preferred and may be employed.

Typically, a ply according to the present invention is formed in the laboratory by winding multi-filament ceramic fiber (or yarn) onto a drum at a predetermined spacing, and covering the wound drum with hardenable liquid polymer (or polymer precursor). The fibers are then cut and removed from the drum surface as a wet sheet or ply, commonly referred to as a "prepreg". Each piece of prepreg is "B-staged" (heated) to advance the resin hardening and to remove volatile solvents in the resin.

Composites having quasi-isotropic thermal properties in-plane according to the present invention are formed by stacking prepregs in specific angular fiber orientations, and heating the unhardened resin with pressure and vacuum to cure and reduce void formation. Alternatively, certain plies may be made inherently quasi-isotropic by the use of woven or non-woven fabrics, or more random fiber orientations (or short or long fibers) more For the purposes of the present invention, variations of in-plane properties with direction of up to 35% are understood to be "quasi-isotropic".

Examples

Example 1

A unidirectional prepreg was prepared using Fiber FP® (a trademark of E.I. DuPont de Nemours & Co., Inc. of Wilmington, DE for high purity alpha alumina multi-filament fiber typically comprised of 200 continuous filaments of alpha alumina), and K-II polyimide resin. The alumina fiber was wound on a drum covered with release paper (Kapton® polyimide film - a trademark of E.I. DuPont de Nemours & Co., Inc., of Wilmington, DE) to a width of 13-14 inches. The fiber spacing was 27 wraps per inch (10.6 wraps/cm).

After winding, K-II Polymer binder solution (42 wt.% cured resin solids in ethanol and N-Methyl Pyridine) was brushed on the fibers uniformly. The calculated amount of binder solution was based on 10-15 wt.% waste solution and a desired cured composite laminate containing approximately 40 vol.% alumina fiber. The wet prepreg was removed from the drum and cut into pieces measuring 13-14" (33-36 cm) on a side. Two of these pieces were placed back to back (resin sides in contact, fibers aligned parallel) to form easily handleable two ply prepregs.

The release paper was removed from one side of the two ply prepreg which was then B-staged twice at 160°C; once between two press platens for twelve minutes and once on a hot plate for 5-10 minutes. This treatment advanced the cure and removed some ethanol and N-methylpyridine present in the binder solution.

The B-staged prepreg was cut into 4.5" (11.4 cm) by 6.5" (16.5 cm) pieces with a metal die (fibers parallel to the 6.5 inch side) and the release paper was removed. Four pieces of the prepreg were stacked (fibers aligned parallel) to provide an eight ply unidirectional laminate which was molded in a steel frame using a steel ram and standard vacuum-bagging techniques (two sided breathing) and the following cure cycle:

25-80°C in thirty minutes,
10-12" Hg (33.86-41 KPa) vacuum,
kiss pressure (<25 psi, <152 KPa)
80-125°C in forty-five minutes,
10-12" Hg vacuum, kiss pressure
125-200°C in seventy-five minutes,
29" Hg (98 KPa) vacuum, kiss pressure
200-225°C in ten minutes,
29" Hg vacuum, kiss pressure
225-230°C in fifty minutes,
29" Hg vacuum, 200 psi (1380 KPa)
350-350°C for three hours,
29" Hg vacuum, 200 psi
350-25°C, cool to room temperature under
29" Hg vacuum, 200 psi

The final composition of the laminate composite is given in Table 1. Its properties are given in Table 2.

It should be noted that any suitable form of heating under pressure and vacuum to cure and reduce void formation, such as in an autoclave, may optionally be employed.

**Example 2**

A second Fiber FP/K-II laminate was prepared as described above in Example 1 with the following differences:
The fiber spacing was 20 wraps per inch (7.9 wraps/cm).
The calculated amount of binder solution was based on 10-15 wt.% waste solution and a cured composite laminate containing approximately 30 vol.% alumina fibers.
Prepreg B-staging time between press platens was 14 minutes.
The characteristics of the final product are given in Tables 1 and 2.

**Example 3**

A third Fiber FP/K-II laminate was prepared as described above in Example 1 with the following differences:
The fiber spacing was 14 wraps per inch (5.5 wraps/cm).
The calculated amount of binder solution was based on 10-15 wt.% waste solution and a cured composite containing approximately 20 vol.% alumina fibers.
Prepreg B-staging time between press platens was 16-17 minutes.
The final composition of the product laminate is given in Table 1. Its properties are given in Table 2.

**Example 4**

A unidirectional prepreg was prepared using Fiber FP and electronic grade epoxy resin, (commercially available from Dow Chemical, Inc. as Quatrex® 5010). The prepreg was made as follows. Three hundred grams of fiber were wound on a drum covered with release paper to a width of 12.5 inches (31.75 cm). The fiber spacing was 34 wraps per inch (13.4 wraps/cm).

After winding, 280 grams of epoxy resin solution were rolled on the fibers uniformly. The wet prepreg was B-staged on the drum as it rotated under three radiant heater lights for one hour, at the end of which the drum temperature was $51°$ C and the prepreg was dry to the touch. The prepreg was removed and cut into pieces measuring 12.5" square. These pieces were further B-staged at $150°$ C in an oven for 2 minutes. B-staging advanced the cure and removed some of the methyl-ethyl-ketone solvent present in the resin solution.

Three pieces of release-paper-removed, B-staged prepreg were stacked on top of one another to form a 12.5" square composite laminate with a fiber orientation of: 0/90/0, or $[0/\overline{90}]_s$ for short. (Here, a $0°$ ply has its fibers parallel to an arbitrarily chosen $0°$ axis and a $90°$ ply has its fibers parallel to an axis at $90°$ to the $0°$ axis.) Against the outer plys, 1 oz., 12.5" square Cu foil face sheets were bonded in situ using the following cure cycle and a press with very smooth platens:

Dried the Cu clad laminate for 1.0-1.5 hours at $105°$ C in a vacuum oven (to remove moisture);
Heated press platens to $177°$ C;
Placed laminate in press, applied 25 psi (172 KPa);
Increased pressure to 300 psi (2069 KPa) after 3-4 minutes (laminate heat-up rate was $5°$ C/minute);
Held 90 minutes at $177°$ C, 300 psi;
Cooled to room temperature under 300 psi.

**Example 5**

A fabric prepreg was prepared using Fiber FP 8 harness satin-weave fabric and epoxy. The prepreg was made as follows. Twelve-inch squares of fabric were dip-coated in an epoxy resin solution bath. After 5 minutes in the bath, the saturated fabric was removed, excess solution was permitted to run off, and the wet prepreg was B-staged at $150°$ C in an oven for 2 minutes.

Three pieces of B-staged prepreg were stacked on top of one another to form a 12" (30.5 cm) square laminate. This laminate was molded between two very smooth press platens using the cure cycle given in Example 4. One oz., 12.5" square Cu foil face sheets were bonded in situ to the surface(s) of the laminate.

**Example 6**

A second Fiber FP/epoxy fabric laminate was prepared as described in Example 5, with the following difference: the fabric was Fiber FP 12 harness satin-weave fabric.

**Example 7**

A unidirectional prepreg was prepared using Fiber FP and a high temperature, thermoplastic polyimide, (K-III Polymer). The prepreg was made as follows. Fiber was wound on a drum covered with release paper to a width of 9.5" (24 cm). The fiber spacing was 20 wraps per inch (8 wraps/cm).

After winding, K-III Polymer binder solution (42 wt% cured resin solids) was brushed on the fibers uniformly; the calculated amount of binder solution was based on 20 wt.% waste solution and a cured K-III composite laminate containing 30 vol.% ceramic fibers. The wet prepreg turned on the drum for 1-2 hours, after which it was removed and cut into pieces measuring 9" (23 cm) x 9.5" (25 cm) and 12.5" (32 cm) x 9.5" (25 cm). These pieces were B-staged at $165°$ C between two press platens for 7 minutes.

The 12.5" x 9.5" pieces of B-staged prepreg were cut into 6 (15 cm) squares with a metal die (fibers parallel to a 6" side). The 9" x 9.5" pieces were cut into 6" squares with a die (fibers were parallel to the diagonal of the square). (These squares are called "45" degree plies.) After removing the release paper, 8 pieces of prepreg were stacked on top of one another to form a 6" square composite laminate with a fiber orientation of 0/+45/-45/90/90/45/+45/0, or $[0/\pm45/90]_s$ for short. This lay-up is called quasi-isotropic because it gives isotropic in-plane properties, which in most cases are desirable.

7

The laminate was molded against a specially prepared, smooth, finely ground steel plate using standard vacuum-bagging techniques (one-sided breathing) and the following cure cycle:

25 - 100° C in 75 minutes, 5" Hg (17 KPa) vacuum, no external pressure;

100 - 100° C for 30 minutes, 5" Hg vacuum, no external pressure;

100 - 180° C in 80 minutes, 29" Hg vacuum, no external pressure;

180 - 180° C for 30 minutes, 29" Hg vacuum, no external pressure;

180 - 343° C in 163 minutes, 29" Hg vacuum, 200 psi;

343 - 343° C for 60 minutes, 29" Hg vacuum, 200 psi;

343 - 25° C, cool to room temperature under 29" Hg vacuum and 200 psi.

Even though a press supplied heat and pressure, any similar device, such as an autoclave, could have been used.

The smooth steel plate produced a smooth composite surface, which could be subsequently metallized (e.g. by adhesive bonding of Cu foil, or by Cu sputtering), photopatterned, and etched for electronic circuitry. Plate preparation was 3 coats of a release agent (Frekote® 44, a trademark of Frekote Corporation), each coat was air-dried for 15-20 minutes and then all three coats were baked on between two press platens at 375° C for 15 minutes.

The final composition of this laminate is given in Table 1.

## Example 8

A second Fiber FP/K-III laminate was prepared as described in Example 7, with the following difference: a 1/2 oz., 6" square Cu foil sheet was placed between the laminate and the steel plate during the vacuum-bagging lay-up and was bonded in situ to the laminate. Potentially, in-situ bonding of the Cu sheet eliminates subsequent metallization of the composite laminate (as described in Example 7).

The final composition of this laminate is given in Table 1.

## Example 9

A unidirectional prepreg was prepared using Fiber FP and K-III Polymer. The prepreg was made as follows. Fiber was wound on a drum covered with release paper to widths of 12.5" and 16.5" (42 cm). The fiber spacing was 34 wraps per inch (13 wraps/cm).

After winding, a K-III Polymer binder solution (43 wt.% cured resin solids) was brushed on the fibers uniformly; the calculated amount of binder solution was based on 20 wt.% waste solution and a cured K-III composite laminate containing 40-50 vol.% ceramic fibers. The wet prepreg turned on the drum for 1-2 hours, after which it was removed and cut into pieces measuring 24.5" (62 cm) x 12.5" and 17.5" (44.5 cm) x 16.5". These pieces were B-staged at 165° C between two press platens for 7 minutes.

The large pieces of B-staged prepreg (24.5" x 12.5") were cut into 12" (30.5 cm) squares (fibers parallel to a 12" direction). The small pieces were cut into 12" squares (fibers were parallel to an axis making a 60° angle with the 12" side). (These squares are called "60" degree plies.) After removing the release paper, six pieces of prepreg were stacked on top of one another to form a 12" square composite laminate with a fiber orientation of: 0/+60/-60/-60/+60/0, or $[0/\pm 60°]_s$ for short. As in Example 7, this composite is called quasi-isotropic because it gives isotropic in-plane properties. This composite may be more desirable than that of Example 7 if reduced thickness of the composite laminate is important, as it may be in some electronic substrates.

The laminate was molded in a press against a specially prepared, mirror chrome finish stainless steel ferrotype plate supplied by Photo Materials Co. of Chicago, IL. using standard vacuum-bagging techniques (one-sided breathing). To the 0° ply next to the photographic plate, an extra 25 wt.% binder solution was added to give a "resin-rich" surface. A resin-rich surface should enhance surface smoothness for enhanced photopatterned line resolution and reduced microwave permittivities or skin effects for faster circuit speeds.

The photographic plate and the resin-rich surface produced an extremely smooth, high quality composite surface, which could be subsequently metallized, photopatterned, and etched for electronic circuitry. Plate preparation was 3 coats of Frekote 44 release agent; each coat was air-dried for 15-20 minutes and then all three coats were baked on between two press platens at 375°C for 15 minutes.

The following cure cycle was employed:

25 - 100°C in 75 minutes, 5" Hg vacuum,
no external pressure;

100 - 100°C for 30 minutes, 5" Hg vacuum,
no external pressure;

100-180°C for 80 minutes, 5" Hg vacuum,
no external pressure;

180 - 180°C for 20 minutes, 29" Hg vacuum,
no external pressure;

180 - 343°C in 163 minutes, 29" Hg vacuum,
no external pressure;

343 - 360°C in 17 minutes, 29" Hg vacuum,
500 psi (3448 KPa);

360 - 360°C for 60 minutes, 29" Hg vacuum,
500 psi;

360 - 150°C, cool under 29" Hg vacuum,
500 psi, remove at 150°C.

Smoothness of the final composite is 9 microinches (0.0023 mm) in an arbitrary X direction and 14 microinches (0.0036 mm) 90° thereto. The final compositon of this laminate is given in Table 1. Its properties are given in Table 2.

## Example 10

A fourth Fiber FP/K-III laminate was prepared as described in Example 9, with the following differences: a 1/2 oz., 12" squre Cu foil sheet (available from Gould, Inc.- JTC POLY"), was placed between the resin-rich surface and a piece of Kapton film during the vacuum-bagging lay-up and was bonded in situ to the laminate. To the bonding side of the Cu foil, a thin layer of K-III binder solution had been applied and B-staged at 165°C for 7 minutes on a hot plate (to promote adhesion). The Kapton film was used as a buffer for the thermal stresses produced by the mismatch in thermal expansion coefficients of the Cu foil and the photographic plate, between which the film was placed.

## Example 11

A fifth Fiber FP/K-III Cu-clad laminate was prepared as described in Example 10, with the following differences:

the laminate measured 3" x 6" (7.6 x 15.2" cm)

no resin-rich surface was used

no binder solution was applied to the Cu foil, which measured 3.5" x 6.5" (8.9 x 16.5 cm) and was dried at 100-125°C in a vacuum oven for 30 minutes before being positioned in the vacuum-bag lay-up

After the first molding of this laminate, a piece of Cu foil was bonded in-situ to the other face of the panel using a press, standard vacuum-bagging techniques and the following cure cycle

Dried Cu foil and Cu clad laminate at 100-125°C in a vacuum oven for 30 minutes;

25 - 343°C in 1 hour (press rate),
29" Hg vacuum, no external pressure;

343 - 360°C in 17 minutes,
29" Hg vacuum, 500 psi;

360-360°C for 60 minutes,
29" Hg vacuum, 500 psi;

360 - 150°C, cool under 29" Hg vacuum and 500 psi, remove at 150°C.

As before, Kapton film was placed between the Cu foil and a photographic plate. Unlike a thermoset matrix, the thermoplasticity or K-III Polymer permits repressing of the composite laminate for auxillary operations such as Cu foil attachment and damage repair.

9

## Example 12

A short fiber laminate was prepared (to simulate a quasi-isotropic "sheet-molding" composite) using Fiber FP and epoxy (Quatrex® 5010). The laminate was made as follows. Thirty-three grams of continuous FP fiber was cut into 1" (2.5 cm) lengths and randomly dispersed in a 7.5" (19 cm) square mold constructed of 2 layers of damming material and release coated (Frekote 33 dried over night in air) Kapton film. One-hundred-twenty-one grams of resin solution were carefully added to this mat such that all fibers were wetted and fiber placement was maintained.

The laminate was molded in a press using standard vacuum bagging techniques (one-sided breathing). The cure cycle was as follows:

25 - 130°C in 38 minutes, 2.5" Hg (8.5 KPa) vacuum, no external pressure

130 - 130°C for 10 minutes, 2.5" Hg vacuum, no external pressure

130 - 177°C in 17 minutes, 29" Hg vacuum, 320 psi (2200 KPa) (applied gradually over the first 5 minutes)

177 - 177°C for 105 minutes, 29" Hg vacuum, 320 psi

177 - 193°C in 6 minutes, 29" Hg vacuum, 320 psi

193 - 193°C for 25 minutes, 29" Hg vacuum, 320 psi

193 - 25°C, cool to room temperature under 29" Hg vacuum and 320 psi

The final composition of the laminate is given in table 1.

## Comparative Example 13

An example of the data presented in U.S. Patent 4,578,308 (Hani, et al) relative to laminates containing alumina paper, reveals a range of in-plane thermal conductivities of 2.5 - 3.3 W/m°K, measured by an undisclosed technique. (Although not specifically stated in the Hani et al. patent, these conductivity values are implied to correspond to the in-plane directions.) Hani's highest thermal conductivity values were achieved with the inclusion of high percentages of filler particles in the epoxy resin. Hani, et al used alumina, boron nitride, and magnesium oxide as fill particles. Hani fails to disclose coefficients of thermal exansion, dielectric constants, or nominal or specific volume percent loadings of alumina in the composites produced.

In contrast, the composite examples of the present invention exhibit in-plane thermal conductivities of from about 5 to 17 W/m°K using the classic longitudinal bar method (described below).

## Comparative Example 14

Neat polyimide (K-II Polymer) resin has the following properties:

Thermal Conductivity     0.25 W.m°K

Dielectric Constant     3.3 @ 1 MHz

Coefficient of Thermal Expansion     65 ppm/°C (RT - 200°C)

Crystalline alpha alumina is usually reported in the literature to have a thermal conductivity of from 15 to 35 W/m°K, and a dielectric constant of 8.6 to 10.6 above 1 KHz. The extropolated value for thermal conductivity of Fiber FP high purity continuous alpha alumina fiber is 30 W/m°K.

## Example 15

A sixth Fiber FP/K-III Polymer laminate was prepared as described in previous examples. The fiber was drum-wound at 40 wraps per inch (15.7 wraps/cm). The laminate was constructed of six plies of prepreg stacked to form a unidirectional laminate. The final composition of the laminate is given in Table 1, and it properties are listed in Table 2.

## Example 16

A seventh Fiber FP/K-III Polymer laminate was prepared as described in Example 15. The laminate was constructed of six plies of prepreg stacked to form a quasi-isotropic $[0/\pm60]_s$ laminate. The final composition of the laminate is given in Table 1, and it properties are listed in Table 2.

Table 1

| Density and Fiber Loading of Composites | | |
|---|---|---|
| Example Number | Density* (g/cc) | Vol.% Ceramic Fibers |
| 1 | 2.40 | 41 |
| 2 | 2.19 | 32 |
| 3 | 1.97 | 25 |
| 7 | 2.00 | 28 |
| 8† | 2.02 | 29 |
| 9 | 2.52 | 47 |
| 12 | 2.20 | 27 |
| 15 | 2.75 | 58 |
| 16 | 2.79 | 60 |

* Measured according to ASTM Standard D 792-66.
† Calculations based on no Cu face sheet present.

All density measurements and volume fraction calculations were made after any poorly consolidated edges or regions of the laminates were removed with a water-cooled diamond saw. In most cases, the volume percent voids in each sample was less than 2%. In Examples 15 and 16, 5 vol.% voids were present.

## Table 2

### Properties of Composite Laminates

| Example Number | Thermal Conductivity (W/m°K) | | | Coefficients of Thermal Expansion (ppm/m°C) | | | Dielectric Constants (out-of-plane) | | |
|---|---|---|---|---|---|---|---|---|---|
| | $k_1$ | $k_2$ | $k_3$ | $\alpha_1$ | $\alpha_2$ | $\alpha_3$ | 1 KHz | 1MHz | 8.5-11.5GHz |
| 1 | 17.0 | — | 1.15 | 7.1(u) 8.4(ud) | 39.9(u) 56.7(ud) | 33.6(u) 60.0(ud) | 5.86 | 4.88 | 5.06 |
| 2 | 10.0 | — | 0.58 | 8.1(u) 10.3(ud) | 42.0(u) 64.0(ud) | 63.3(u) 45.4(ud) | 5.40 | 4.43 | 4.74 |
| 3 | 11.6 | — | 0.51 | 12.2(u) 14.3(ud) | 46.7(u) 58.3(ud) | 52.2(u) 37.9(ud) | 4.57 | 3.70 | 4.11 |
| 9 | 9.8 | 9.0 | 0.72 | 8.5(u) 10.2(d) | 8.9(u) 9.2(d) | 98.1(u) 92.2(d) | — | 4.73 | — |
| 12 | 6.2 | — | 0.51 | 8.9(d) | 13.8(d) | 114.6(d) | 4.16 | 3.32 | 5.05 |
| 14 | — | — | 0.25 | — | — | 65.4(d) | 3.40 | 3.31 | 2.87 |
| 15 | 16.0 | 5.0 | 1.93 | 9.8(d) | 32.9(d) | — | — | 6.36 | — |
| 16 | — | 9.4 | 1.32 | 9.6(d) | 9.3(d) | — | — | 6.28 | — |

—— = No data available.

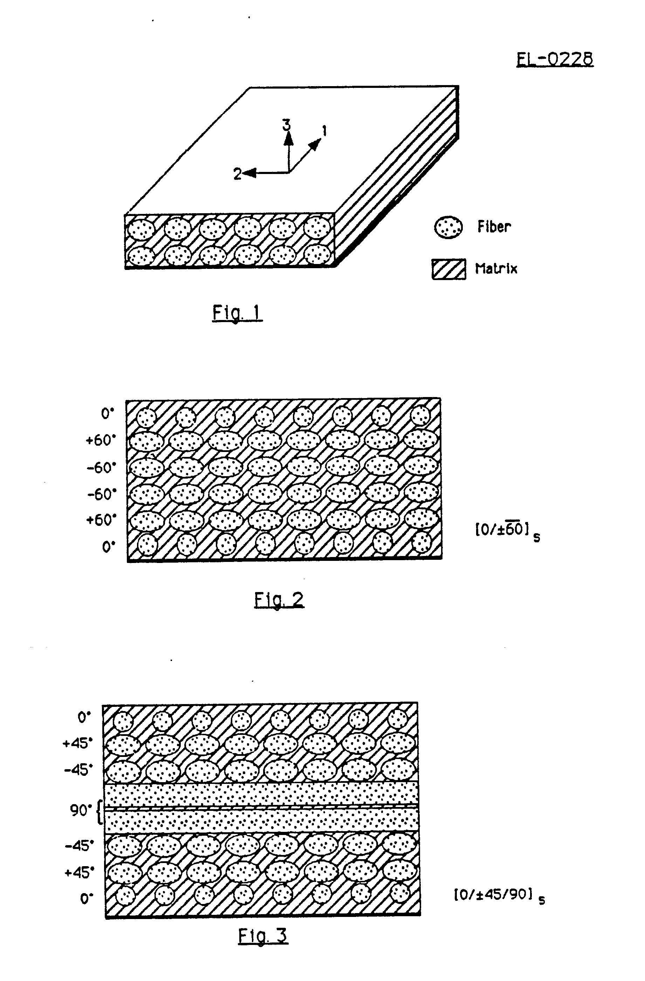

Table 2 Notes:
   All subscripts per axes of Figs. 1-3
   Dielectric Constants and Thermal Conductivity
measured at 300°K,
   $\alpha$ measured over 50-200°C, (Except Ex. 12: $\alpha_1, \alpha_2$
measured over 50-140°C, $\alpha_3$ over 60-150°C)


Test Methods:
$k_1$ & $k_2$   -   Guarded Longitudinal Bar
$k_3$           -   Electronic Flash


Coefficients of Thermal Expansion Sample Conditioning:
   (d) - dried over night @ 100°C under vacuum
         before testing.
   (u) - sample not dried prior to testing.
   (ud)- tested undried, then dried over night
         @ 100°C under vacuum and retested.


   Expansion measurements made using a DuPont 9900
Thermal Mechanical Analyzer.


Dielectric Constants:        1KHz and 1MHz measured
                             according to ASTM Standard D 150-81
                             8.5 - 11.5GHz evaluated from S parameter
                             measurements on an HP 8410B network
                             analyzer, with a wave guide, electric
                             field in the fiber direction.

The example data demonstrate the relationship between fiber loading and thermal conductivity, coefficient of thermal expansion, and dielectric constant. Using only fibers of alpha alumina arrayed in-plane, superior characteristics of the plies and laminates are achieved. At the lowest loadings (5 vol.% ceramic e.g. AlN), thermal conductivities on the order of 5 W/m°K may be achieved, while at loadings above 50 vol.% (e.g. Fiber FP, thermal conductivities as high as 17 W/m°K are observed. Thermal conductivity perpendicular to the fiber direction (out-of-plane for quasi-isotropic plies and laminates) is observed in all cases to exceed that of neat polyimide resin (observed values are greater than approximately 0.3 W/m°K). With increased loading of ceramic fiber, thermal conductivity in this direction is markedly enhanced. Coefficients of thermal expansion in the fiber direction (designated axis 1 in Table 2), or in-plane (designated axes 1 and 2 in Table 2) for quasi-isotropic plies and laminates, are observed to be below 14 ppm/°C.

Additional enhancement of out-of-plane thermal conductivity may be achieved by filling the resin matrix with a thermally conductive material in the form of particles, platelets, or whiskers - a common technique in the prior art, or by splaying the multifilament yarns to make plies as thin as possible. Plies of only 1.5 yarn diameters have been produced in the laboratory, and these are expected to exhibit high thermal conductivity in the out-of-plane direction due to the high cross-sectional area of the fibers relative to the matrix.

Because the samples used in testing generally represent less than 5% of the entire sample (pieces of composite approximately 1 - 2.5cm wide by 1-7 cm long), anomalous results may be obtained. Local properties at the point of measurement may vary significantly from the average gross properties of an entire sample. In particular, imperfect molding techniques, which introduce voids and inconsistencies in the composite product could cause greatly varied localized property variations.

Measurements of thermal conductivity reported in Table 2 were conducted according to the following methods:

## Guarded Longitudinal Bar:

Rod samples of length about 1.25 - 2.5" (3.2 - 7 cm) and of square, rectangular or circular cross-section with between 1/16 (0.4 sq.cm) and 1/64 (0.1 sq.cm) sq. inches cross-sectional area (A) are used. These are pre-drilled with four holes, one at each end and two spaced about 1/3 and 2/3 of the way along the sample. One end of the sample is attached to a temperature controlled "cold sink" while the sample heater is attached to the other end. Thermocouples are inserted into the holes along the sample. The heat flow rate (dQ/dt) provided to the sample heater is measured accurately using four-point electrical techniques. The temperature difference (dT) measured by the thermocouples, which are cross-calibrated at a range of temperatures, is combined with the separation of the thermocouples (dx), to provide the temperature gradient along the sample (dT/dx). The thermal conductivity, k, is then obtained from the relationship:

$$(dQ/dt) = kA(dT/dx)$$

To minimize the direct radiation heat losses the sample is shielded along its entire length by a heated guard provided with a separate heater and separate thermocouples located directly opposite those on the sample. Computer control matches the temperature of a point on the sample to a parallel point on the guard thus providing a comparable temperature gradient in both sample and guard. The space between the sample and the guard is filled with a dispersed fibrous insulation to further reduce radiative losses. The sample and associated guard are mounted with a uniform temperature corresponding to the temperature mid-point of the sample.

The entire experimental system of sample, guard and outer furnace is mounted in a vacuum and attached to a variable temperature cryo-pyrostat which can operate between 4°K and 573°K. Liquid helium or nitrogen is used as the coolant below room temperature and iced water as the coolant above room temperature. A temperature controller is used to maintain intermediate temperatures constant to 0.1°K. Experiment control and data acquisition are by micro-computer.

The system is checked for consistency by periodic measurements of standard materials such as Armco Iron, high density sintered alumina and a specified glass. The lower limit of measurement on this system is about 1 W m°K. The accuracy of measurement is 5% under normal conditions though it may be reduced to better than 3% under special conditions.

## Electronic Flash

Square or rectangular samples with sides about 1/2" (1.3cm) to 3/8" (1cm) are prepared by coating one surface with a graphite heater layer. The temperature of the second surface is monitored by a thermocouple. An electrical pulse of about 3 Joule is delivered to the heater in a 50 msec. square pulse. The temperature rise of the second face is monitored before, during and after the pulse. The temperature history is analyzed to obtain the thermal diffusivity (a'). In addition, sine the amount of deposited energy is known from the magnitude of the entering pulse, it is possible to determine the specific heat ($C_p$). By multiplying both parameters along with the mass density, the thermal conductivity (k) can be obtained.

The technique is particularly useful for determining thermal conductivity and specific heat for composite materials in the z-axis direction (i.e. out-of-plane). It can be applied readily for temperatures between about 30 K (-240°C) and 500 K (+220°C). Extension to lower temperatures is possible with some modification of the design. Rapid data acquisition is achieved by an automated micro-computer system. Thermal diffusivity and specific heat are determined to about 5% and thermal conductivity to about 10% accuracies.

Statement of Industrial Utility

The composites of the present invention can be used as circuit boards and packages for the mounting of microelectronic devices and circuits.

**Claims**

1. A composite ply comprised of a planarly oriented plurality of high thermal conductivity, low thermal expansion coefficient, moderately low dielectric constant crystalline ceramic fibers embedded in a low dielectric constant resin matrix, the composite having an out-of-plane dielectric constant of no more than 12 to 1 KHz or higher frequency, a thermal expansion coefficient in the fiber direction of no more than 14 ppm/$^\circ$C, and a thermal conductivity in the fiber direction of at least 5 W/m $^\circ$K, and a thermal conductivity transverse to the fiber direction of at least 0.3 W/m $^\circ$K.

2. A composite ply comprised of a planarly oriented plurality of high thermal conductivity, low thermal exansion coefficient, moderately low dielectric constant crystalline ceramic fibers embedded in a low dielectric constant resin matrix, the composite having an out-of-plane dielectric constant of no more than 12 to 1 KHz or higher frequency, a quasi-isotropic in-plane thermal expansion coefficient of no more than 14 ppm/$^\circ$C, and a thermal conductivity in the plane of the ply of at least 5 W/m $^\circ$K, and out of the plane of the ply of at least 0.3 W/m $^\circ$K.

3. The composite ply of Claim 1 or Claim 2 wherein the thermal conductivity of said crystalline ceramic fibers is at least 8 W/m $^\circ$K.

4. The composite ply of Claim 1 or Claim 2 wherein the thermal condictivity of said crystalline ceramic fibers is at least 25 W/m $^\circ$K.

5. The composite ply of Claim 1 or Claim 2 wherein the dielectric constant of said crystalline ceramic fibers is no more than 80 (measured at room temperature and at 1 KHz or higher frequency).

6. The composite ply of Claim 1 or Claim 2 wherein the dielectric constant of said crystalline ceramic fibers is no more than 50 (measured at room temperature and at 1 KHz or higher frequency).

7. The composite ply of Claim 1 or Claim 2 wherein the dielectric constant of said crystalline ceramic fibers is no more than 12 (measured at room temperature and at 1 KHz or higher frequency).

8. The composite ply of Claim 1 or Claim 2 wherein the coefficient of thermal expansion of said crystalline ceramic fibers is no more than 14 ppm/$^\circ$C from 50 to 200$^\circ$C.

9. The composite ply of Claim 1 or Claim 2 wherein the coefficient of thermal expansion of said crystalline ceramic fibers is no more than 9 ppm/$^\circ$C from 50 to 200$^\circ$C.

10. The composite ply of Claim 1 or Claim 2 wherein the dielectric constant of said resin matrix is no more than 5 (measured at room temperature and at 1 KHz or higher frequency).

11. The composite ply of Claim 1 or Claim 2 wherein the ceramic fibers comprise at least 30 volume per cent of the composite.

12. The composite ply of Claim 1 or Claim 2 wherein the ceramic fibers comprise at least 45 volume per cent of the composite.

13. The composite ply of Claim 1 or Claim 2 wherein the ceramic fibers are composed of a pure, dense, crystalline ceramic material selected from the group of alumina, aluminum nitride, silicon carbide, alpha quartz, beryllium oxide, boron nitride, silicon nitride, magnesium oxide, and diamond and mixtures thereof.

14. The composite ply of Claim 13 wherein said ceramic material is further mixed with one or more non-ceramic fiber materials.

15. The composite ply of Claim 1 or Claim 2 wherein the ceramic fibers are composed of alpha alumina.

16. The composite ply of Claim 1 or Claim 2 wherein the ceramic fibers are composed of alpha alumina which is at least 97% pure.

17. The composite ply of Claim 1 or Claim 2 wherein the ceramic fibers are composed of aluminum nitride.

18. The composite ply of Claim 1 or Claim 2 wherein the fibers are substantially continuous along one axis within the ply.

19. The composite ply of Claim 1 or Claim 2 wherein the fibers are no more than 25 microns in diameter.

20. The composite ply of Claim 1 wherein the ceramic fibers are aligned parallel to one another in the plane of the ply.

21. The ply of Claim 2 wherein the ceramic fibers are in random in-plane array.

22. The ply of Claim 2 wherein the ceramic fibers are in a woven array.

23. The ply of Claim 2 wherein the ceramic fibers are in a non-woven array.

24. A laminate comprising the composite ply of Claim 1 laminated with at least one additional composite ply also having a plurality of fibers aligned parallel to one another in the plane of the additional ply, the aligned fibers in the first ply and in the additional plies being angularly displaced from one another by a predetermined amount to maintain in-plane rotational symmetry of 2 or greater and out-of-plane mirror symmetry.

25. The laminate of claim 24 comprising at least six plies wherein the fibers of each ply are in collimated array, and are oriented with predetermined angular symmetry to achieve quasi-isotropic in-plane physical properties.

26. The laminate of Claim 25 wherein said predetermined angular symmetry is 0°, +60°, -60°, -60°, +60°, 0° with respect to an arbitrarily designated 0° axis.

27. The laminate of Claim 25 wherein said predetermined angular symmetry is 0°, +45°, -45°, 90°, 90°, -45°, +45°, 0° with respect to an arbitrarily designated 0° axis.

28. The composite ply of Claim 1 or Claim 2 wherein the resin is selected from the group of polyimides, polyamides, epoxies, polyetherimides, polyamide-imides, fluoropolymers, polyarylates, polyetherketones, polysulfones, polyphenylene sulfides, bismaleimide resins, phenolic resins polyesters, polybutadiene, polyetheretherketones, polyetherketoneketones, cyanate esters, and modified resins and copolymers of these.

29. The composite poly of Claim 28 wherein the resin matrix is filled with a predetermined volume percentage of a particulate filler material.

30. The composite ply of Claim 1 or Claim 2 wherein the resin is a polyimide.

31. The composite ply of Claim 1 or Claim 2 wherein the resin is an epoxy.

32. An electronic substrate comprised of the composite of Claim 1 or Claim 2 or Claim 24 and, disposed in preselected patterns on at least one ply surface thereof, an electrically conductive material forming an electric circuit, the composite being adapted to rapidly conduct heat from any source of heat in the circuit to the surrounding area of the ply and through the thickness of the ply to the opposite face.

33. The electronic substrate of Claim 32 wherein the fibers contained in the ply are composed of alpha alumina.

34. The electronic substrate of Claim 32 wherein the fibers contained in the ply are composed of aluminum nitride.

35. The electronic substrate of Claim 32 wherein the resin in the ply is a polyimide.

35. The electronic substrate of Claim 32 wherein the resin in the ply is an epoxy resin.

36. The method of making the composite ply of Claim 1 comprising the steps of:

a. positioning said ceramic fibers in a predetermined array;

b. coating or impregnating said ceramic fiber array with a hardenable liquid polymer such that the polymer coating on the individual fibers forms bonding surfaces between contiguous fibers; and

c. hardening said polymer to effect bonding between contiguous fibers such that less than 5 volume per cent voids are formed.

37. The method of making the composite laminate of Claim 24 comprising the steps of:

a. positioning said ceramic fibers in a predetermined array;

b. coating or impregnating said ceramic fiber array with a heat- hardenable liquid polymer such that the polymer coating on the individual fibers forms bonding surfaces between contiguous fibers;

c. hardening said polymer to effect bonding between contiguous fibers to make a ply such that less than 5 volume per cent voids are formed;

d. forming the laminate by overlaying a plurality of plies in which the fibers are oriented in a predetermined array such that the polymer coating on the fibers forms bonding surfaces between contiguous fibers; and

e. treating the laminate of step d. to effect hardening of the liquid polymer and bonding between contiguous fibers such that less than 5 volume per cent voids are formed

38. A composite suitable for use as a printed circuit board comprising the ply of Claim 1 or Claim 2 having a thin layer of metal bonded to at least one surface thereof.

39. A composite suitable for use as a printed circuit board comprising the laminate of Claim 24 having a thin layer of metal bonded to at least one surface of one ply thereof.

40. The composite of Claim 38 wherein said metal is copper.

16

41. The composite of Claim 39 wherein said metal is copper.

42. A method of making the composite of Claim 38 comprising the steps of:

a. positioning said ceramic fibers in an array;

b. coating or impregnating said ceramic fiber array with a hardenable liquid polymer such that the polymer coating on the individual fibers forms bonding surfaces between contiguous fibers such that less than 5 volume per cent voids are formed;

c. placing a metal sheet adjacent to at least one surface of said polymer-coated fiber array; and

d. hardening said polymer to effect bonding between contiguous fibers and said metal sheet such that less than 5 volume per cent voids are formed.

43. The method of making the composite of Claim 38 comprising the steps of:

a. positioning said ceramic fibers in an array;

b. coating or impregnating said ceramic fiber array with a hardenable liquid polymer such that the polymer coating on the individual fibers forms bonding surfaces between contiguous fibers and less than 5 volume per cent voids are formed;

c. adding additional liquid polymer to at least one surface of said array;

d. placing a metal sheet adjacent to at least one surface of said polymer-coated fiber array; and

e. hardening said polymer to effect bonding between contiguous fibers and said metal sheet such that less than 5 volume per cent voids are formed.

44. The method of Claim 42 or Claim 43 wherein said metal sheet is precoated with said polymer.

45. A method of making the composite of Claim 39 comprising the steps of:

a. positioning said ceramic fibers in an array;

b. coating or impregnating said ceramic fiber array with a heat-hardenable liquid polymer such that the polymer coating on the individual fibers forms bonding surfaces between contiguous fibers;

c. hardening said polymer to effect bonding between contiguous fibers to make a ply such that less than 5 volume per cent voids are formed;

d. forming the laminate by overlaying a plurality of plies in which the fibers are oriented in a predetermined array such that the polymer coating on the fibers forms bonding surfaces between contiguous fibers;

e. placing a metal sheet adjacent to at least one surface of said laminate; and

f. heating the laminate of step e. to effect hardening of the liquid polymer and bonding between contiguous fibers and said metal sheet such that less than 5 volume percent voids are formed.

46. The ply of Claim 1 or Claim 2 wherein at least one surface is coated with additional resin to provide a smooth surface in order to enhance photo-process resolution of circuit patterns and microwave properties of the ply.

47. The ply of Claim 46 wherein said smooth surface contains no nonuniformities of greater than 20 microinches in height.

48. The composite of Claim 39 wherein at least one of the outer surfaces is coated with additional resin to provide a smooth surface in order to enhance photo-process resolution of circuit patterns and microwave properties of the composite.

EL-0228

Fiber

Matrix

Fig. 1

0°
+60°
−60°
−60°
+60°
0°

$[0/\pm\overline{60}]_s$

Fig. 2

0°
+45°
−45°
90°
−45°
+45°
0°

$[0/\pm45/90]_s$

Fig. 3